# EUROPEAN PATENT SPECIFICATION

(11) **EP 3 833 172 B1**
(45) Date of publication and mention of the grant of the patent: **18.10.2023**
(21) Application number: 18928343.5
(22) Date of filing: 31.07.2018
(51) Int. Cl.: H05K 13/08

(54) **TRACE ASSISTANCE DEVICE**
SPURUNTERSTÜTZUNGSVORRICHTUNG
DISPOSITIF D'AIDE À LA TRACE

(43) Date of publication of application: 09.06.2021
(73) Proprietor: Fuji Corporation, Chiryu-shi, Aichi 472-8686 (JP)
(72) Inventor: ICHIKAWA Ryo, Chiryu-shi, Aichi 472-8686 (JP)
(74) Representative: Grünecker Patent- und Rechtsanwälte PartG mbB
(86) International application number: PCT/JP2018/028693
(87) International publication number: WO 2020/026350

(56) References cited:
- JP-A- H04 161 823
- JP-A- 2012 190 821
- JP-A- 2016 086 084
- JP-A- 2017 199 740
- JP-A- 2017 224 051
- JP-A- 2018 018 917
- US-A1- 2004 243 256
- US-A1- 2008 178 042

## Description

### Technical Field

The present invention relates to a trace assistance device.

### Background Art

A trace assistance device is applied to a board work machine used for the production of board products. JP-A-2017-199740 discloses a component mounter as the board work machine. The component mounter of JP-A-2017-199740 executes a mounting process for mounting a component on a board, and records an operation history in a trace log, the history of which being a driving device or the like through the execution of the mounting process. With such a configuration, for example, in a case where a trigger event such as a mounting error occurs, the mounting process can be traced by analyzing the trace log, and a cause of the mounting error can be identified.

US 2008/178042 A1 discloses a troubleshooting support device including a keyword file storage unit in which keyword files holding keywords constituted with character strings contained in logs related to trouble that occurs in the substrate processing apparatus stored in advance, are stored. A keyword to be used for log search, selected from a keyword file specified based upon input information provided via an input unit, is set, and also a category-specific log file to be used for log analysis is set based upon input information provided via the input unit. Logs in the category-specific log file having been set are extracted and incorporated, and an analysis log file is created by sorting the extracted logs in time sequence.

It is the object of the present invention to provide an improved a trace assistance device for a board work machine.

This object is solved by the subject matter of the independent claims.

Embodiments are defined in the dependent claims.

### Technical Problem

With the configuration of JP-A-2017-199740, it is possible to acquire the trace log when the trigger event such as the mounting error occurs. However, in reality, although the trace log is analyzed, there are many cases where the direct causes of the mounting errors cannot be identified. Therefore, it is conceivable to acquire a trace log in which a past operation history is recorded and compare these trace logs. Therefore, a traceability of the board work machine is improved, but if a large amount of trace logs are accumulated, the trace logs for use of identifying the cause of the trigger event may not be easily acquired.

It is an object of the present specification to provide a trace assistance device capable of acquiring a trace log suitable for use in identifying a cause of a work error or the like from multiple trace logs recorded by a board work machine. Solution to Problem

The present specification discloses a trace assistance device for st- a board work machine, including: a storage section configured to classify multiple trace logs, each being recorded an operation history of the board work machine performing a predetermined work on a board, into a category relating to an operation environment or an operation control, and store the multiple trace logs, wherein a trace log is classified by adding multiple tags corresponding to the category relating to the operation environment or the operation control; and a log acquisition section configured to define the trace log, in which a series of operations relating to the trigger event is recorded, as a reference log in a case where a predetermined trigger event occurs in a work by the board work machine, wherein the log acquisition section assumes that the trigger event is associated with a mounting error, and acquire, from the multiple trace logs stored in the storage section, a related log belonging to a same category or a similar category with the reference log, wherein a log is determined to belong to a similar category if a certain number of tags or more are common.

### Advantageous Effect of the Invention

With such a configuration, it is possible to easily acquire, from the trace log recorded in the past, the related log belonging to the same category or the similar category with the reference log when the trigger event occurs. Therefore, for example, a same analysis process on the reference log and the related log is performed, so that it is possible to perform a trace such as comparing results of the analysis process for both and identifying a cause of the trigger event. As a result, it is possible to suppress a decrease in production efficiency due to the occurrence of the trigger event.

### Brief Description of Drawings

Fig. 1 is a schematic view illustrating a production system including a trace assistance device in an embodiment.
Fig. 2 is a schematic view illustrating a configuration of a component mounter in the production line of Fig. 1.
Fig. 3 is a flowchart illustrating a mounting process by the component mounter.
Fig. 4 is a diagram illustrating various data including a trace log.
Fig. 5 is a flowchart illustrating a trace assistance process.

### Description of Embodiments

### 1. Overview of Production System 1

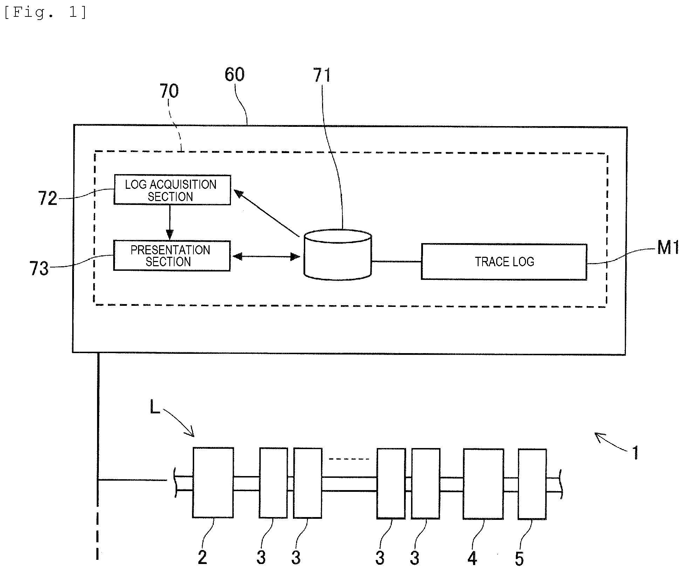

A trace assistance device is applied to, for example, a board work machine constituting production system 1 of a board product. In the present embodiment, an aspect is illustrated in which the trace assistance device is configured such that a mounting process by component mounter 3 as a board work machine is an assistance target. As illustrated in Fig. 1, production system 1 is configured by one or more production lines L and host computer 60 that collectively manages production lines L.

### 2. Composition of Production Line L

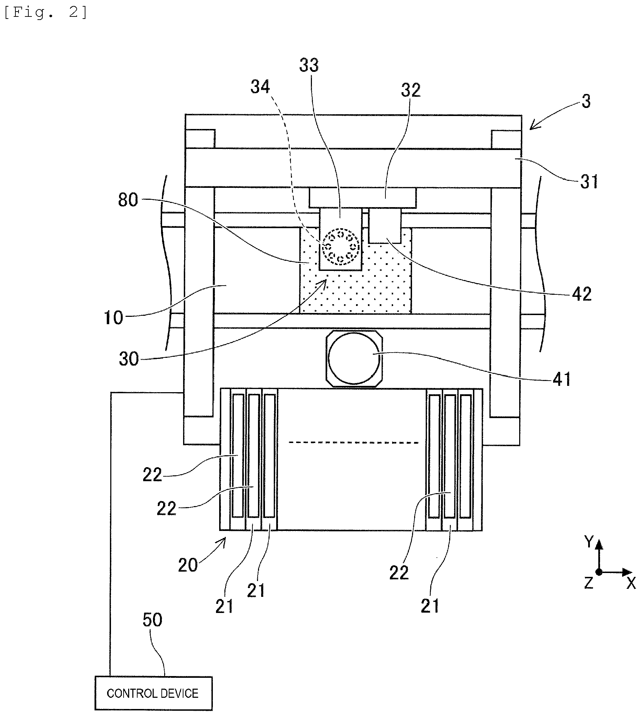

Production line L is configured by installing multiple board work machines in a conveyance direction of board 80 (see Fig.2). Each of multiple board work machines is communicably connected to host computer 60. As illustrated in Fig. 1, production line L includes printer 2, multiple component mounters 3, reflow furnace 4, and inspector 5 as multiple board work machines.

Printer 2 prints a paste-like solder to a mounting position of the component in conveyed-in board 80. Each of multiple component mounter 3 mounts the component on board 80 conveyed from an upstream side of production line L. A configuration of component mounter 3 will be described later. Reflow furnace 4 heats board 80 conveyed from the upstream side of production line L, and performs soldering by melting the solder on board 80. Inspector 5 inspects whether an appearance or a function of the board product produced by production line L is normal.

A configuration of production line L may be appropriately added or changed in accordance with, for example, the type of the board product to be produced. Specifically, in production line L, a buffer device for temporarily holding board 80 to be conveyed, a board supplying device, a board flipping device, various inspection devices, a shield mounting device, an adhesive application device, a chip transfer device, an ultraviolet ray irradiation device, and the like can be appropriately installed.

### 3. Configuration of Component Mounter 3

Component mounter 3 executes a mounting process of mounting the component on board 80. As illustrated in Fig. 2, component mounter 3 includes board conveyance device 10, component supply device 20, component transfer device 30, part camera 41, board camera 42, and control device 50. In the following description, it is assumed that a first direction of a horizontal direction and a left-right direction of component mounter 3 is X-direction, a second direction of the horizontal direction intersecting X-direction and a front-rear direction of component mounter 3 is Y-direction, and a vertical direction (front-rear direction in Fig. 2) orthogonal to X-direction and Y-direction is Z-direction.

Board conveyance device 10 is constituted by a belt conveyor and a positioning device, or the like. Board conveyance device 10 subsequently conveys board 80 in the conveyance direction and positions board 80 at a predetermined position in the machine. After the mounting process of the component is completed by component mounter 3, board conveyance device 10 conveys out board 80 to an outside of the machine of component mounter 3.

Component supply device 20 supplies the component to be mounted on board 80. Component supply device 20 includes multiple slots 21 disposed side by side in X-direction, and feeders 22 respectively set in multiple slots 21. Feeder 22 feeds and moves a carrier tape in which multiple components are stored. Thus, feeder 22 supplies the component to be picked up at a supply position provided on a distal end side of feeder 22.

Component transfer device 30 transfers the component supplied by component supply device 20 to a predetermined mounting position (work position) on board 80 conveyed in the machine by board conveyance device 10. Head driving device 31 of component transfer device 30 moves moving table 32 in the horizontal direction (X-direction and Y-direction) by a linear motion mechanism. Mounting head 33 is exchangeably fixed to moving table 32 by a clamp member (not illustrated). Mounting head 33 supports multiple suction nozzles 34 rotatably and liftably. Suction nozzle 34 picks up the component which is supplied by feeder 22 by the supplied negative pressure air. As described above, suction nozzle 34 is a holding member that holds the component by being supplied by the negative pressure air.

Part camera 41 and board camera 42 are digital imaging devices each having an imaging element such as a CMOS. Part camera 41 and board camera 42 perform imaging based on a control signal, and sends out the image data acquired by the imaging. Part camera 41 is fixed to a base such that an optical axis is upward in Z-direction. Part camera 41 is configured to be capable of imaging the component held by suction nozzle 34 of mounting head 33 from below. Board camera 42 is fixed to moving table 32 such that the optical axis is downward in Z-direction and moves integrally with mounting head 33 with the movement of moving table 32. Board camera 42 is configured to be capable of imaging board 80 from above.

Control device 50 mainly configured by a CPU, various memories, and a control circuit. Control device 50 executes the mounting process of mounting the component on board 80. The mounting process described above includes a process repeating, over multiple times, a pick-and-place cycle (hereinafter, also referred to as a "PP cycle") for picking up the component supplied by component supply device 20 and mounting the component on the mounting position in board 80.

In the mounting process, control device 50 controls an operation of component transfer device 30 based on a control program or the like for designating the mounting position on board 80, as a result of information and image processing output from various sensors. Thus, positions and angles of multiple suction nozzles 34 supported by mounting head 33 are controlled. Details of the mounting process by component mounter 3 will be described later.

### 4. Mounting Process by Component Mounter 3

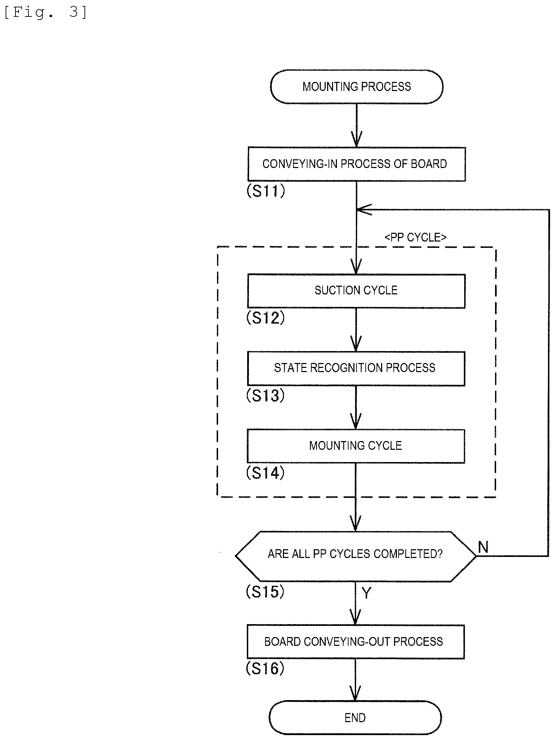

A mounting process by component mounter 3 will be described with reference to Fig. 3. In the mounting process, control device 50 first executes a conveying-in process of board 80 (S11). In the conveying-in process of board 80, board conveyance device 10 positions board 80 at a predetermined position in the machine while conveying board 80 in the machine of component mounter 3.

Next, control device 50 executes a suction cycle in which the components are subsequently picked up by multiple suction nozzles 34 (S12). More particularly, control device 50 moves mounting head 33 above feeder 22 that supplies a predetermined type of component in component supply device 20. Then, control device 50 lowers suction nozzle 34 to pick up the component, and then lifts suction nozzle 34 again. In the suction cycle, the movement of mounting head 33 and the lowering and lifting of suction nozzle 34 as described above are repeated, and multiple components are respectively held by suction nozzles 34.

Subsequently, control device 50 executes a state recognition process for recognizing the holding state of the components held respectively in multiple suction nozzles 34 (S13). More particularly, control device 50 moves mounting head 33 above part camera 41 and sends out an imaging command to part camera 41. Control device 50 performs the image processing of the image data acquired by imaging of part camera 41 and recognizes a posture (position and angle) of the component held in each of multiple suction nozzles 34.

Thereafter, control device 50 executes a mounting cycle in which the components are subsequently mounted on board 80 by multiple suction nozzles 34 (S14). More particularly, control device 50 moves mounting head 33 above a predetermined mounting position on board 80. At this time, control device 50 corrects the position and the angle of suction nozzle 34 based on a result of the state recognition process (S13). Then, control device 50 lowers suction nozzle 34 to mount the component, and then lifts suction nozzle 34 again. In the mounting cycle, the movement of mounting head 33, and the lowering and lifting of suction nozzle 34 as described above are repeated to respectively mount multiple components on board 80.

In a case where the mounting of all the components to be mounted on present board 80 is not completed (S15: No), control device 50 repeatedly executes the PP cycle (S12 to S14) until the mounting is completed. In a case where the mounting of all the components is completed (S15: Yes), control device 50 executes a conveying-out process of board 80 (S16). In the conveying-out process of board 80, board conveyance device 10 conveys out board 80 to the outside of the machine of component mounter 3 while opening board 80 which is positioned.

### 5. Configuration of Trace Assistance Device 70

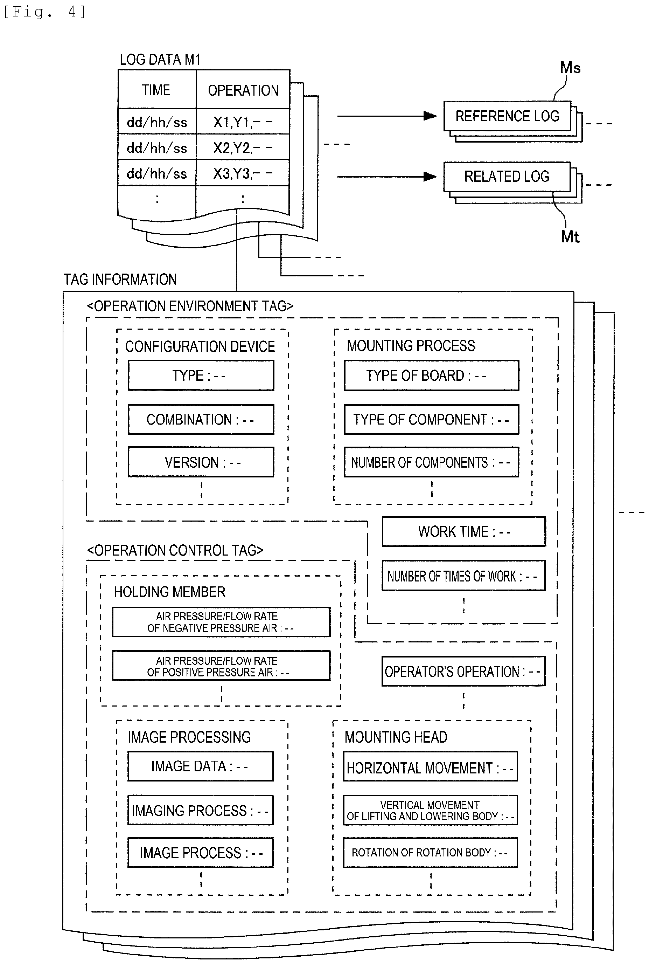

In the present embodiment, host computer 60 functions as trace assistance device 70 of the board work machine by configuration devices and installed software. In the present embodiment, trace assistance device 70 assists a trace process for identifying a cause of a mounting error occurred in component mounter 3. In the trace process described above, trace log M1 (see Fig. 4) is used in which an operation history of component mounter 3 is recorded.

### 5-1. Trace Log M1 and Tag

Here, the board work machine such as component mounter 3 performs a predetermined work on board 80, and records the operation history associated with the work in trace log M1. For example, component mounter 3 writes the operation history in trace log M1 every time various devices (board conveyance device 10, component supply device 20, component transfer device 30, and the like) perform various operations (the conveyance of board 80, the supply of the component, the pickup and mounting of the component, and the like) when executing the mounting process for mounting the component as the predetermined work. The update of trace log M1 may be performed at regular intervals (for example, every several µs) during the operations of the various devices.

In the operation history described above, for example, in a case of the operation of moving mounting head 33 to a predetermined XY position by feedback control, an operation command for the head driving device 31 that moves mounting head 33, the present XY position of mounting head 33, and various signals of the feedback control may be included. Further, in trace log M1, an operation command or the like relating to a vertical movement of a lifting and lowering body provided in mounting head 33 can be recorded as the operation history. The lifting and lowering body includes, for example, a holder for supporting a holding member such as suction nozzle 34.

Further, in trace log M1, an operation command or the like relating to a rotation of a rotation body provided in mounting head 33 can be recorded as the operation history. The rotation body includes, for example, a holder for supporting the holding member such as suction nozzle 34, and a rotary head for rotatably supporting multiple suction nozzles 34 around R-axis parallel to Z-axis. Further, in trace log M1, an operation command or the like relating to the imaging process for acquiring the image data used for various types of image processing, a type and a setting value of the image processing, an execution procedure of multiple types of image processing, and the like can be recorded as an operation history.

Trace log M1 as described above is generated and updated by writing in control device 50, and is also generated and updated by various configuration devices constituting component mounter 3. The configuration devices described above includes, for example, board conveyance device 10, component supply device 20, and component transfer device 30. Furthermore, feeder 22 constituting component supply device 20 and mounting head 33 constituting component transfer device 30 may be configured as individual configuration device, and these may be configured to generate and update trace log M1.

The configuration devices described above are removably configured with respect to component mounter 3, and the type and quantity in accordance with the board product to be produced, and a combination thereof may be changed. Further, in the configuration device, in a case where the firmware that performs a predetermined function is incorporated in advance, a version of the firmware is set in accordance with a functions required for the mounting process to be executed. In the configuration described above, for example, control device 50 records, in trace log M1, the operation command sent out to the configuration device. On the other hand, the configuration device records, in trace log M1, a received operation command and an operation in accordance with the operation command.

As illustrated in Fig. 4, tags in accordance with various operation environments or operation controls in component mounter 3 are added to trace log M1 generated and updated by control device 50 and the configuration devices. The various "operation environments" described above are environments when component mounter 3 executes the mounting process or the like. Therefore, for example, tags in accordance with the types and combinations of the configuration devices, and the version of the firmware are added to trace log M1. In addition, for example, a tag in accordance with at least one of a work time and the number of times of work of component mounter 3 or the configuration device is added to trace log M1.

The "work time" of component mounter 3 or the configuration device is an accumulated operation time from the turn-on of a power source and predetermined maintenance of component mounter 3 to the present time (when the operation history is recorded). For example, in a case where the configuration device is mounting head 33, the operation time is a time from replacement with mounting head 33 having completed maintenance until the present time. In addition, for example, in a case where the configuration device is suction nozzle 34, the "number of times of work" of component mounter 3 or the configuration device is the accumulated number of times suction nozzle 34 picks up or mounts the component from the replacement with suction nozzle 34 having completed maintenance until the present time (when the operation history is recorded). Further, in the present embodiment, tags in accordance with board 80 (type and identification information) that is a target of the mounting process of the component, the type of the component mounted on board 80, and the number of the components are added to trace log M1.

Further, the various "operation controls" described above are controls for component mounter 3 to execute the mounting process and the like. That is, in a case where at least one of the horizontal movement of mounting head 33, the vertical movement of the lifting and lowering body provided in mounting head 33, and the rotation of the rotation body provided in mounting head 33 is recorded in trace log M1 as the operation history, the tags in accordance with the respective operation histories are added to trace log M1. Further, the tags in accordance with the image data used for the image processing executed in the mounting process, the imaging process for acquiring the image data, and the image processing are added to trace log M1.

In addition, in a case where an operation of an operator on component mounter 3 is recorded as the operation history in trace log M1, a tag in accordance with the operation is added to trace log M1. Further, in a case where the air pressure or the flow rate of the negative pressure air or the positive pressure air supplied to suction nozzle 34 is recorded in trace log M1 as the operation history, a tag in accordance with each of the operation histories is added to trace log M1. Control device 50 and the configuration device add the tags described above to trace log M1 based on part data in which a content of the control program, a result of the recognition process by the image processing, and a shape and a mounting condition for each component type are set.

In the present embodiment, each of control device 50 and the configuration device generates trace log M1 so that a file size becomes, for example, a predetermined value or less, and adds multiple tags to each file of trace log M1. On the other hand, for example, in order to correspond to a case where the mounting process is changed halfway in trace log M1 recorded in one file, or the configuration device is changed accordingly, each of control device 50 and the configuration device may be configured to add a separate tag for each predetermined range corresponding to the mounting process or the type of the configuration device among multiple rows in trace log M1.

### 5-2. Detailed Configuration of Trace Assistance Device 70

As described above, in order to improve traceability, component mounter 3 is configured such that various devices (control device 50 and the configuration device) cooperating in the mounting process respectively record trace log M1. Thus, it is possible to avoid shortage of trace log M1 required for the trace process. On the other hand, as trace log M1 increases, an amount of information capable of being referred to also increases. Thus, in addition to trace log M1 at the time of occurrence of the trigger event such as the mounting error, for example, in a case where the past operation history is further referred to, it is not easy to acquire significant trace log M1.

Therefore, trace assistance device 70 of the present embodiment adopts a configuration capable of acquiring trace log M1 suitable for the trace process from multiple trace logs M1 recorded by component mounter 3. Specifically, as illustrated in Fig. 1, trace assistance device 70 includes storage section 71, log acquisition section 72, and presentation section 73. Storage section 71 is configured by an optical drive device such as a hard disk device, a flash memory, or the like. Storage section 71 classifies multiple trace logs M1 in which operation histories of component mounter 3 are recorded into the category relating to the operation environment or the operation control, and stores multiple trace logs M1.

In the present embodiment, storage section 71 inputs and stores multiple trace logs M1 generated in various board work machines including multiple component mounters 3 constituting production line L. The "category relating to the operation environment or the operation control" described above corresponds to a tag that can be added to trace log M1. For example, the tag indicating the type of mounting head 33 added to trace log M1 corresponds to the category relating to the type of mounting head 33. As described above, storage section 71 stores multiple trace logs M1 to which one or more tags are added.

In a case where a predetermined trigger event occurs in the work performed by component mounter 3, log acquisition section 72 acquires related log Mt belonging to the same category or a similar category with reference log Ms from multiple trace logs M1 stored in storage section 71. Here, trace assistance device 70 assumes trace log M1, in which a series of operations relating to the trigger event is recorded, as reference log Ms. For example, in a case where the trigger event is an error occurred during the horizontal movement of mounting head 33 in the mounting process, the "series of operations relating to the trigger event" described above may be an operation from the start of the horizontal movement to the stop in accordance with the occurrence of the error.

Trace assistance device 70 may be arbitrarily settable by the operator as to a range of what degree the series of operations relating to the trigger event are included. In the example described above, one PP cycle including the horizontal movement may be a series of operations without a series of operations from the start to the stop of the horizontal movement, or a series of operations may be set from the start of the mounting process to the stop of the horizontal movement after board 80 is conveyed in. In addition, the series of operations may also include operations after the occurrence of the trigger event.

In addition to a case where reference log Ms is one of multiple trace logs M1 stored in storage section 71, reference log Ms may be trace log M1 generated by component mounter 3 and written so as to record a series of operations relating to the trigger event. In addition, log acquisition section 72 can acquire multiple reference logs Ms recorded in various cooperating devices based on an acquisition condition by the operator or the like. Log acquisition section 72 recognizes the category of reference log Ms based on the tag added to reference log Ms.

In a case where no tag is added to reference log Ms, for example, when component mounter 3 abnormally stops (hangs up) in an inoperable state, or the like, log acquisition section 72 may recognize the category (corresponding to the tag to be added) of reference log Ms based on various information. More specifically, log acquisition section 72 recognizes the category of reference log Ms based on the content of the control program used in the mounting process at the time of occurrence of the trigger event, the result of the recognition process by the image processing, and the part data in which a shape and a mounting condition for each component type are set.

Log acquisition section 72 acquires related log Mt classified into a category that is the same as or similar with the category of recognized reference log Ms. Regarding the similarity between reference log Ms and related log Mt, the similarity can be adjusted by the setting of the operator, for example, in a case where a certain number of tags or more are common among multiple tags, the category is determined to be similar or the like. The operator may adjust a determination criterion of the similarity in accordance with the type and occurrence frequency of the trigger event, or the like.

Further, the similarity between reference log Ms and related log Mt may be weighted for each of multiple tags, and related log Mt acquired may change in accordance with, for example, the type of the trigger event or the like. Therefore, depending on the type of the trigger event or the like, a tag that is indispensable for the similar category may occur, or a tag that is not used for the determination of similarity may occur. Therefore, the number of acquired related logs Mt can be narrowed down in advance, and a process load thereafter can be reduced.

Here, in a case where the trigger event is a work error detected during the execution of the work such as the mounting process by component mounter 3, log acquisition section 72 identifies reference log Ms in which a series of operations relating to the work error is recorded. In a case where the trigger event is a work error detected in the inspection of board 80 after the execution of the work by component mounter 3, log acquisition section 72 determines that the work error occurs in the work by component mounter 3 to be executed, and identifies reference log Ms in which a series of operations relating to the work error is recorded. Log acquisition section 72 acquires related log Mt from multiple trace logs M1 based on the identified reference log Ms.

For example, it is assumed to be determined that the mounting position of the component is abnormal by an appearance inspection by inspector 5. In this case, log acquisition section 72 assumes that the trigger event (mounting error) occurs with respect to the mounting operation in which the mounting of the component is attempted, and sets, as reference log Ms, trace log M1 in which the series of operations relating to the mounting operation is recorded. Log acquisition section 72 acquires reference log Ms and related log Mt belonging to the same category or the similar category with reference log Ms.

Presentation section 73 of trace assistance device 70 presents reference log Ms and related log Mt to the worker. In the present embodiment, presentation section 73 presents reference log Ms and related log Mt to the worker by displaying them on a display device (not illustrated) of host computer 60. The display device described above is, for example, a display constituting host computer 60.

Further, in the present embodiment, presentation section 73 presents reference log Ms and related log Mt in a state where regulated operations included in the series of operations are checked in each of reference log Ms and related log Mt. The "regulated operation" is an operation that can be arbitrarily set by the operator for each type of trigger event or a range of the series of operations, and for example, in a case where one PP cycle including the horizontal movement of mounting head 33 is a series of operations, the horizontal movement at the time of shifting from the suction cycle (S12) to the state recognition process (S13) in the PP cycle can be set to the regulated operation.

Here, if the operation history included in acquired reference log Ms and related log Mt is large, the amount of information becomes large, and the work efficiency of the trace process decreases. On the other hand, as described above, by presenting reference log Ms and related log Mt in a state where presentation section 73 checks the regulated operation, it is easy to recognize common points and difference points between both. Therefore, the efficiency of the trace process can be improved, and a load of the trace process can be reduced.

Further, in the present embodiment, presentation section 73 extracts the operation of the operator on component mounter 3 from each of reference log Ms and related log Mt, and presents the operation in a state where the order of the respective operations thereof is checked. Here, the trigger event may occur due to an order error of the operation of the operator. Therefore, as described above, presentation section 73 presents the order of the operations of the operator in a comparable manner so that it is easy to identify the presence or absence of the order error of the operation of the operator and an operation of the error.

### 6. Trace Assistance Process by Trace Assistance Device 70

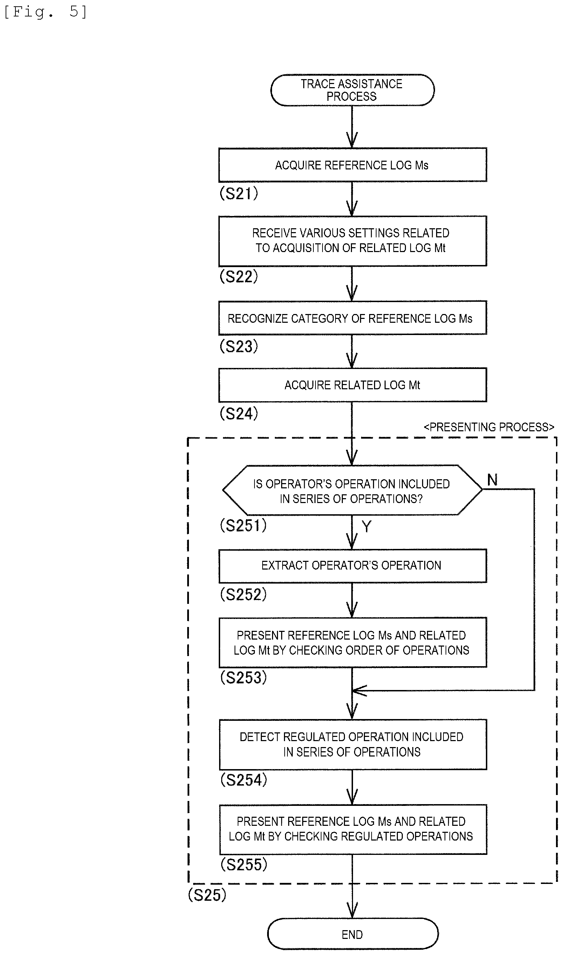

A trace assistance process by trace assistance device 70 having the configuration described above will be described with reference to Figs. 4 and 5. Here, trace assistance device 70 assists, as contrast, the trace process for identifying a cause of the trigger event that occurs in the mounting process by component mounter 3 which is the board work machine. Further, it is also assumed that storage section 71 stores in advance the control program and part data used in the mounting process, and multiple trace logs M1 generated in the mounting process that has already been executed.

In the assistance process, as illustrated in Fig. 5, log acquisition section 72 first identifies reference log Ms based on the trigger event and acquires reference log Ms (S21). Log acquisition section 72 may receive the designation of reference log Ms by the operator and acquire designated reference log Ms. Log acquisition section 72 may acquire, as reference log Ms, both trace log M1 generated by a predetermined configuration device in addition to trace log M1 generated by control device 50, based on the type of the trigger event and the like, the presence or absence of cooperation of various devices at the time of occurrence of the trigger event, or the like.

Next, trace assistance device 70 receives various settings relating to the acquisition of related log Mt by the operator (S22). The various settings described above include a range of the series of operations, and the determination criterion of similarity between reference log Ms and related log Mt. Therefore, an adjustment is performed by the operator, and the adjustment is reflected on the number of related logs Mt acquired in a subsequent step, and the like. In addition, in a case where various settings are not input by the operator, an initial setting value or a previous setting value may be input.

Next, log acquisition section 72 recognizes the category of reference log Ms based on the tag added to reference log Ms (S23). In a case where no tag is added to reference log Ms, log acquisition section 72 recognizes the category of reference log Ms based on the content of the control program used in the mounting process when the trigger event occurs. At this time, log acquisition section 72 may add, to reference log Ms, tags added by various devices.

Log acquisition section 72 acquires, from multiple trace logs M1 stored in storage section 71, related log Mt having the same or similar category with reference log Ms recognized in S23 (S24). At this time, log acquisition section 72 may notify the operator of the number of acquired related logs Mt, receive again various settings relating to the acquisition of related log Mt, and acquire again related log Mt. Thus, the number of related logs Mt is adjusted accordingly.

Related log Mt acquired in S24 is not limited to trace log M1 recorded in the mounting process executed in the past by component mounter 3 in which the trigger event occurs. For example, trace log M1 recorded in the mounting process performed in the past by the same or different component mounters 3 constituting the same or different production lines L may be acquired as being classified into the same category or the similar category with reference log Ms relating to the trigger event of this time.

Thereafter, presentation section 73 executes the presenting process of reference log Ms and related log Mt (S25). Specifically, in a case where the operation by the operator is included in the series of operations in reference log Ms and related log Mt (S251: Yes), presentation section 73 first extracts the operation by the operator on component mounter 3 from each of reference log Ms and related log Mt (S252). Then, presentation section 73 presents reference log Ms and related log Mt in a state where the order of the respective operations is checked (S253).

In a case where the operation by the operator is not included in the series of operations in reference log Ms and related log Mt (S251: No) or in a case where the presentation of S253 is performed, presentation section 73 detects the regulated operation included in the series of operations in each of reference log Ms and related log Mt (S254). Then, presentation section 73 presents reference log Ms and related log Mt in a state where each of the detected regulated operations is checked (S255).

When presenting reference log Ms and related log Mt in S253 or S255, presentation section 73 may emphasize and display a predetermined operation or the regulated operation by the operator, such as changing other items and display colors. Therefore, the visibility by the operator can be improved, and the efficiency of the trace process can be further improved. Further, in a case of presenting multiple reference logs Ms and multiple related logs Mt, presentation section 73 may preferentially present, for example, an output from the configuration device directly relating to the trigger event, and assistantly present outputs from other configuration devices cooperating with the configuration device thereof.

In addition, in a case of presenting multiple related logs Mt, presentation section 73 may preferentially present a log having a high similarity with reference log Ms. At this time, presentation section 73 may also present a degree of similarity of presented related log Mt. This allows the operator to regard the information as a reliable index when referencing related log Mt. Further, presentation section 73 may also present whether a trigger event similar to that of reference log Ms occurs and in a case where the trigger event occurs, timing thereof in a case of the occurrence of the trigger event with respect to presented related log Mt.

### 7. Effects of Configuration of Embodiment

Trace assistance device 70 of the board work machine (component mounter 3) described above includes storage section 71 configured to classify, into the category relating to the operation environment or the operation control, and store trace logs M1 in which the operation history of component mounter 3 performing a predetermined work on board 80 is recorded; and log acquisition section 72 configured to use, in a case where a predetermined trigger event occurs in the work by component mounter 3, trace log M1 in which the series of operations relating to the trigger event is recorded as reference log Ms, and acquire, from trace log M1 stored in storage section 71, related log Mt belonging to the same category or the similar category with reference log Ms.

With such a configuration, even if the amount of trace log M1 stored in storage section 71 becomes large, it is possible to acquire related log Mt belonging to the same category or the similar category with reference log Ms. Thus, for example, by executing a same analysis process in reference log Ms and related log Mt, it is possible to trace such as comparing the results of the analysis process for both and identifying the cause of the trigger event. As a result, it is possible to suppress a decrease in production efficiency due to the occurrence of the trigger event.

### 8. Modified Form of Embodiment

### 8-1. Classification of Trace Log M1

In the embodiment, trace log M1 is configured to be classified by adding multiple tags corresponding to the category relating to the operation environment or the operation control in various devices (control device 50 and the configuration device) that generate trace log M1. On the other hand, the process of adding the tag to trace log M1 may be performed by an external device such as trace assistance device 70.

More specifically, trace assistance device 70 acquires trace log M1 from, for example, the board work machine constituting production line L via a network, and acquires a control program, configuration information indicating the machine configuration, and the like. Therefore, trace assistance device 70 may add an appropriate tag to acquired trace log M1 so that trace log M1 is classified into a predetermined category.

As described above, trace log M1 is classified into predetermined categories by adding multiple tags. On the other hand, in an embodiment not according to the claimed invention, trace assistance device 70 may classify trace log M1 into the predetermined category by other methods. For example, trace log M1 may be classified by designating a category name in which a character string corresponding to the tag illustrated in the embodiment is coupled as a file name of trace log M1 or a folder name in which trace log M1 is stored.

### 8-2. Configuration of Trace Assistance Device

In the embodiment, trace assistance device 70 is configured to be incorporated into host computer 60. On the other hand, trace assistance device 70 may adopt other various forms to configuring one function of host computer 60. For example, trace assistance device 70 may be a dedicated external device communicably connected to production line L and host computer 60. At this time, trace assistance device 70 may be configured to be connected to the board work machine via Internet. The same effects as those of the embodiment are also achieved in any configuration.

### 8-3. Others

In the embodiment, trace assistance device 70 is configured such that component mounter 3 that is the board work machine is the target, and the trace process is assisted for performing identification of the cause of the mounting error generated in component mounter 3 or the like. On the other hand, the trace assistance device 70 may be configured such that the board work machine (printer 2, adhesive application device, or the like) other than component mounter 3 is the target. For example, in a case where the board work machine is printer 2, the moving head for horizontally moving a squeegee used for printing the solder corresponds to mounting head 33 of the embodiment.

In the embodiment, component mounter 3 is configured to include suction nozzle 34 that picks up the component by the supplied negative pressure air as the holding member for holding the component. On the other hand, the holding member may be a chuck for gripping the component by the negative pressure air or the positive pressure air supplied in the mounting process. In such a configuration, the category into which trace log M1 is classified may include a category based on the air pressure of the negative pressure air or the positive pressure air or flow rate. Therefore, as exemplified in the embodiment, it is easy to acquire related log Mt from trace log M1 classified into the category relating to the operation control for the holding member.

### Reference Signs List

1: production system, 2: printer, 3: component mounter (board work machine), 4: reflow furnace, 5: inspector, 30: component transfer device, 33: mounting head (moving head), 34: suction nozzle (holding member), 50: control device, 60: host computer, 70: trace assistance device, 71: storage section, 72: log acquisition section, 73: presentation section, 80: board, M1: trace log, Ms: reference log, Mt: related log

## Claims

1. A trace assistance device (70) for a board work machine, comprising:
a storage section (71) configured to classify multiple trace logs (M1), each being recorded an operation history of the board work machine performing a predetermined work on a board (80), into a category relating to an operation environment or an operation control, and store the multiple trace logs, wherein a trace log (M1) is classified by adding multiple tags corresponding to the category relating to the operation environment or the operation control; and
a log acquisition section (72) configured to define the trace log, in which a series of operations relating to a trigger event is recorded, as a reference log (Ms) in a case where a predetermined trigger event occurs in a work by the board work machine, wherein the log acquisition section assumes that the trigger event is associated with a mounting error, and acquire, from the multiple trace logs stored in the storage section, a related log (Mt) belonging to a same category or a similar category with the reference log, wherein a log is determined to belong to a similar category if a certain number of tags or more are common.

2. The trace assistance device for
a board work machine according to claim 1, wherein the
category includes a category based on at least one of a type of a configuration device constituting the board work machine, a combination of multiple configuration devices, and a version of firmware incorporated in the configuration device.

3. The trace assistance device for
a board work machine according to claim 1 or 2, wherein
the category includes a category based on at least one of a work time and the number of times of the work of the board work machine or a configuration device constituting the board work machine.

4. The trace assistance device for a board work machine according to any one of claims 1 to 3, wherein the board work machine is to perform the predetermined work by moving a moving head (33) to each of multiple work positions, and
wherein the category includes a category based on at least one of a horizontal movement of the moving head, a vertical movement of a lifting and lowering body provided on the moving head, and a rotation of a rotation body provided on the moving head in the board work machine.

5. The trace assistance device for a board work machine according to any one of claims 1 to 4, wherein the board work machine is to perform the predetermined work based on a result of image processing of image data acquired by imaging of a camera (41, 42) installed in the machine, and wherein the category includes a category based on at least one of the image data used for the image processing, an imaging process for acquiring the image data, and the image processing.

6. The trace assistance device for a board work machine according to any one of claims 1 to 5, wherein the category includes a category based on an operation of an operator on the board work machine.

7. The trace assistance device for a board work machine according to any one of claims 1 to 6,
wherein the trigger event is a work error detected during execution of the work by the board work machine, and wherein the log acquisition section is configured to acquire the related log from the multiple trace logs stored in the storage section in a case where the work error occurs.

8. The trace assistance device for a board work machine according to any one of claims 1 to 7, wherein the trigger event is a work error detected in an inspection on the board after execution of the work by the board work machine, and
wherein in a case where the work error is detected by the inspection, the log acquisition section supposes that the work error occurs in the work by the executed board work machine, and acquires the related log from the multiple trace logs stored in the storage section.

9. The trace assistance device for a board work machine according to any one of claims 1 to 8, wherein in a case where the trigger event occurs, the log acquisition section acquires the reference log and the related log from the multiple trace logs stored in the storage section, and
wherein the trace assistance device further comprises a presentation section that presents the reference log and the related log to a worker.

10. The trace assistance device for a board work machine according to claim 9, wherein the presentation section is configured to present the reference log and the related log in a state where regulated operations included in the series of operations are checked in each of the reference log and the related log.

11. The trace assistance device for a board work machine according to claim 9 or 10, wherein
the presentation section is configured to extract an operation of an operator on the board work machine from each of the reference log and the related log, and
to present the reference log and the related log in a state where an order of respective operations is checked.

12. The trace assistance device for a board work machine according to any one of claims 1 to 11, wherein the board work machine is a component mounter for mounting a component on the board.

13. The trace assistance device for a board work machine according to claim 12, wherein the category includes a category based on the board, a type of the component mounted on the board, and the number of the components.

14. The trace assistance device for a board work machine according to claim 12 or 13, wherein
the component mounter is configured to include a holding member for holding the component by supplying negative pressure air or positive pressure air to the holding member in the predetermined work, and
wherein the category includes a category based on an air pressure or a flow rate of the negative pressure air or the positive pressure air supplied to the holding member.

## Patentansprüche

1. Ablaufverfolgungsunterstützungsvorrichtung (70) für eine Leiterplattenbearbeitungsmaschine, umfassend:
einen Speicherabschnitt (71), der dazu konfiguriert ist, mehrere Ablaufverfolgungsprotokolle (M1), von denen jedes einen Betriebsverlauf der Leiterplattenbearbeitungsmaschine, die eine vorgegebene Arbeit an einer Leiterplatte (80) durchführt, aufgezeichnet hat, in eine Kategorie zu klassifizieren, die sich auf eine Betriebsumgebung oder eine Betriebssteuerung bezieht, und die mehreren Ablaufverfolgungsprotokolle zu speichern, wobei ein Ablaufverfolgungsprotokoll (M1) durch Hinzufügen mehrerer Markierungen klassifiziert wird, die der Kategorie entsprechen, welche sich auf die Betriebsumgebung oder die Betriebssteuerung bezieht; und
einen Protokollerfassungsabschnitt (72), der dazu konfiguriert ist, das Ablaufverfolgungsprotokoll, in dem eine Reihe von Operationen in Bezug auf ein Auslöseereignis aufgezeichnet ist, als ein Referenzprotokoll (Ms) in einem Fall zu definieren, in dem ein vorgegebenes Auslöseereignis bei einer Arbeit durch die Leiterplattenbearbeitungsmaschine auftritt, wobei der Protokollerfassungsabschnitt annimmt, dass das Auslöseereignis mit einem Montagefehler verbunden ist, und aus den mehreren Ablaufverfolgungsprotokollen, die in dem Speicherabschnitt gespeichert sind, ein zugehöriges Protokoll (Mt) erfasst, das zu einer gleichen Kategorie oder einer ähnlichen Kategorie wie das Referenzprotokoll gehört, wobei bestimmt wird, dass ein Protokoll zu einer ähnlichen Kategorie gehört, wenn eine bestimmte Anzahl von Markierungen oder mehr gemeinsam sind.

2. Ablaufverfolgungsunterstützungsvorrichtung für eine Leiterplattenbearbeitungsmaschine nach Anspruch 1, wobei die Kategorie eine Kategorie einschließt, die auf mindestens einem Typ einer Konfigurationsvorrichtung, welche die Leiterplattenbearbeitungsmaschine bildet, einer Kombination mehrerer Konfigurationsvorrichtungen und einer Version der in die Konfigurationsvorrichtung integrierten Firmware basiert.

3. Ablaufverfolgungsunterstützungsvorrichtung für eine Leiterplattenbearbeitungsmaschine nach Anspruch 1 oder 2, wobei die Kategorie eine Kategorie einschließt, die auf mindestens einem von einer Arbeitsdauer und der Anzahl von Malen der Bearbeitung der Leiterplattenbearbeitungsmaschine oder einer die Leiterplattenbearbeitungsmaschine bildenden Konfigurationsvorrichtung basiert.

4. Ablaufverfolgungsunterstützungsvorrichtung für eine Leiterplattenbearbeitungsmaschine nach einem der Ansprüche 1 bis 3, wobei die Leiterplattenbearbeitungsmaschine die vorgegebene Arbeit durch Bewegen eines Bewegungskopfes (33) zu jeder von mehreren Arbeitspositionen ausführen soll, und
wobei die Kategorie eine Kategorie einschließt, die auf mindestens einem aus einer horizontalen Bewegung des beweglichen Kopfes, einer vertikalen Bewegung eines Hebe- und Senkkörpers, der an dem beweglichen Kopf vorgesehen ist, und einer Drehung eines Drehkörpers, der an dem beweglichen Kopf in der Leiterplattenbearbeitungsmaschine vorgesehen ist, basiert.

5. Ablaufverfolgungsunterstützungsvorrichtung für eine Leiterplattenbearbeitungsmaschine nach einem der Ansprüche 1 bis 4, wobei die Leiterplattenbearbeitungsmaschine die vorgegebene Arbeit auf der Grundlage eines Ergebnisses der Bildverarbeitung von Bilddaten durchführen soll, die durch die Bildgebung einer in der Maschine installierten Kamera (41, 42) erfasst wurden, und wobei die Kategorie eine Kategorie einschließt, die auf mindestens einem aus den für die Bildverarbeitung verwendeten Bilddaten, einem Bildgebungsverfahren zur Erfassung der Bilddaten und der Bildverarbeitung basiert.

6. Ablaufverfolgungsunterstützungsvorrichtung für eine Leiterplattenbearbeitungsmaschine nach einem der Ansprüche 1 bis 5, wobei die Kategorie eine Kategorie einschließt, die auf einer Operation eines Bedieners an der Leiterplattenbearbeitungsmaschine basiert.

7. Ablaufverfolgungsunterstützungsvorrichtung für eine Leiterplattenbearbeitungsmaschine nach einem der Ansprüche 1 bis 6, wobei das Auslöseereignis ein Arbeitsfehler ist, der während der Ausführung der Arbeit durch die Leiterplattenbearbeitungsmaschine erkannt wird, und wobei der Protokollerfassungsabschnitt dazu konfiguriert ist, das zugehörige Protokoll von den mehreren Ablaufverfolgungsprotokollen, die in dem Speicherabschnitt gespeichert sind, in einem Fall zu erfassen, in dem der Arbeitsfehler auftritt.

8. Ablaufverfolgungsunterstützungsvorrichtung für eine Leiterplattenbearbeitungsmaschine nach einem der Ansprüche 1 bis 7, wobei das Auslöseereignis ein Arbeitsfehler ist, der bei einer Inspektion der Leiterplatte nach Ausführung der Arbeit durch die Leiterplattenbearbeitungsmaschine festgestellt wird, und
wobei in einem Fall, in dem der Arbeitsfehler durch die Inspektion erkannt wird, der Protokollerfassungsabschnitt annimmt, dass der Arbeitsfehler bei der Arbeit durch die ausgeführte Leiterplattenbearbeitungsmaschine auftritt, und das zugehörige Protokoll aus den mehreren im Speicherabschnitt gespeicherten Ablaufverfolgungsprotokollen erfasst.

9. Ablaufverfolgungsunterstützungsvorrichtung für eine Leiterplattenbearbeitungsmaschine nach einem der Ansprüche 1 bis 8, wobei in einem Fall, in dem das Auslöseereignis auftritt, der Protokollerfassungsabschnitt das Referenzprotokoll und das zugehörige Protokoll aus den mehreren im Speicherabschnitt gespeicherten Ablaufverfolgungsprotokollen erfasst, und
wobei die Ablaufverfolgungsunterstützungsvorrichtung ferner einen Präsentationsabschnitt umfasst, der das Referenzprotokoll und das zugehörige Protokoll einem Arbeiter präsentiert.

10. Ablaufverfolgungsunterstützungsvorrichtung für eine Leiterplattenbearbeitungsmaschine nach Anspruch 9, wobei der Präsentationsabschnitt dazu konfiguriert ist, das Referenzprotokoll und das zugehörige Protokoll in einem Zustand zu präsentieren, in dem geregelte Operationen, die in der Reihe von Operationen enthalten sind, sowohl im Referenzprotokoll als auch im zugehörigen Protokoll überprüft werden.

11. Ablaufverfolgungsunterstützungsvorrichtung für eine Leiterplattenbearbeitungsmaschine nach Anspruch 9 oder 10, wobei der Präsentationsabschnitt dazu konfiguriert ist, eine Operation eines Bedieners an der Leiterplattenbearbeitungsmaschine sowohl aus dem Referenzprotokoll als auch aus dem zugehörigen Protokoll zu extrahieren und das Referenzprotokoll und das zugehörige Protokoll in einem Zustand zu präsentieren, in dem eine Reihenfolge der jeweiligen Operationen überprüft wird.

12. Ablaufverfolgungsunterstützungsvorrichtung für eine Leiterplattenbearbeitungsmaschine nach einem der Ansprüche 1 bis 11, wobei die Leiterplattenbearbeitungsmaschine eine Komponentenbestückungsmaschine zur Montage einer Komponente auf der Leiterplatte ist.

13. Ablaufverfolgungsunterstützungsvorrichtung für eine Leiterplattenbearbeitungsmaschine nach Anspruch 12, wobei die Kategorie eine auf der Leiterplatte basierende Kategorie, einen Typ der auf der Leiterplatte montierten Komponente und die Anzahl der Komponenten einschließt.

14. Ablaufverfolgungsunterstützungsvorrichtung für eine Leiterplattenbearbeitungsmaschine nach Anspruch 12 oder 13, wobei
die Komponentenbestückungsmaschine so konfiguriert ist, dass sie ein Halteelement zum Halten der Komponente durch Zuführen von Unterdruckluft oder Überdruckluft zu dem Halteelement in der vorgegebenen Arbeit enthält, und
wobei die Kategorie eine Kategorie einschließt, die auf einem Luftdruck oder einer Durchflussrate der Unterdruckluft oder der Überdruckluft basiert, die dem Halteelement zugeführt wird.

## Revendications

1. Dispositif d'assistance au traçage (70) pour une machine de travail sur carte, comprenant :
une section de stockage (71) configurée pour classer de multiples journaux de traçage (M1), dans chacun desquels est enregistré un historique des opérations de la machine de travail sur carte mettant en oeuvre un travail prédéterminé sur une carte (80), dans une catégorie relative à un environnement opérationnel ou à un contrôle opérationnel, et pour stocker les multiples journaux de traçage, dans lequel un journal de traçage (M1) est classé en ajoutant de multiples étiquettes correspondant à la catégorie relative à l'environnement opérationnel ou au contrôle opérationnel ; et
une section d'acquisition de journaux (72) configurée pour définir le journal de traçage, dans lequel une série d'opérations relatives à un événement déclencheur est enregistrée sous forme d'un journal de référence (Ms) dans le cas où un événement déclencheur prédéterminé se produit lors d'un travail réalisé par la machine de travail sur carte, dans lequel la section d'acquisition de journaux suppose que l'événement déclencheur est associé à une erreur de montage, et pour acquérir, parmi les multiples journaux de traçage stockés dans la section de stockage, un journal associé (Mt) appartenant à une catégorie identique ou similaire à celle du journal de référence, dans lequel un journal est déterminé comme appartenant à une catégorie similaire si un certain nombre au moins d'étiquettes sont communes.

2. Dispositif d'assistance au traçage pour une machine de travail sur carte selon la revendication 1, dans lequel la catégorie comprend une catégorie basée sur au moins un élément parmi un type de dispositif de configuration constituant la machine de travail sur carte, une combinaison de multiples dispositifs de configuration, et une version du micrologiciel incorporé dans le dispositif de configuration.

3. Dispositif d'assistance au traçage pour une machine de travail sur carte selon la revendication 1 ou 2, dans lequel la catégorie comprend une catégorie basée sur au moins un élément parmi un temps de travail et le nombre d'occurrences de travail de la machine de travail sur carte ou d'un dispositif de configuration constituant le machine de travail sur carte.

4. Dispositif d'assistance au traçage pour une machine de travail sur carte selon l'une quelconque des revendications 1 à 3, dans lequel la machine de travail sur carte doit mettre en oeuvre le travail prédéterminé en déplaçant une tête mobile (33) jusqu'à chaque position parmi de multiples positions de travail, et
dans lequel la catégorie comprend une catégorie basée sur au moins un mouvement horizontal de la tête mobile, un mouvement vertical d'un corps de levage et d'abaissement pourvu sur la tête mobile, et une rotation d'un corps de rotation pourvu sur la tête mobile dans la machine de travail sur carte.

5. Dispositif d'assistance au traçage pour une machine de travail sur carte selon l'une quelconque des revendications 1 à 4, dans lequel la machine de travail sur carte doit mettre en oeuvre le travail prédéterminé sur la base d'un résultat de traitement d'image de données d'image acquises par imagerie d'une caméra (41, 42) installée dans la machine, et dans lequel la catégorie comprend une catégorie basée sur au moins un élément parmi les données d'image utilisées pour le traitement d'image, un processus d'imagerie pour acquérir les données d'image, et le traitement d'image.

6. Dispositif d'assistance au traçage pour une machine de travail sur carte selon l'une quelconque des revendications 1 à 5, dans lequel la catégorie comprend une catégorie basée sur une opération d'un opérateur sur la machine de travail sur carte.

7. Dispositif d'assistance au traçage pour une machine de travail sur carte selon l'une quelconque des revendications 1 à 6, dans lequel l'événement déclencheur est une erreur de travail détectée pendant l'exécution du travail par la machine de travail sur carte, et dans lequel la section d'acquisition de journaux est configurée pour acquérir le journal associé parmi les multiples journaux de traçage stockés dans la section de stockage dans le cas où l'erreur de travail se produit.

8. Dispositif d'assistance au traçage pour une machine de travail sur carte selon l'une quelconque des revendications 1 à 7, dans lequel l'événement déclencheur est une erreur de travail détectée lors d'une inspection sur la carte après l'exécution du travail par la machine de travail sur carte, et
dans lequel, dans le cas où l'erreur de travail est détectée par l'inspection, la section d'acquisition de journaux suppose que l'erreur de travail se produit dans le travail exécuté par la machine de travail sur carte et acquiert le journal associé parmi les multiples journaux de traçage stockés dans la section de stockage.

9. Dispositif d'assistance au traçage pour une machine de travail sur carte selon l'une quelconque des revendications 1 à 8, dans lequel, dans le cas où l'événement déclencheur se produit, la section d'acquisition de journaux acquiert le journal de référence et le journal associé parmi les multiples journaux de traçage stockés dans la section de stockage, et
dans lequel le dispositif d'assistance au traçage comprend en outre une section de présentation qui présente le journal de référence et le journal associé à un travailleur.

10. Dispositif d'assistance au traçage pour une machine de travail sur carte selon la revendication 9, dans lequel la section de présentation est configurée pour présenter le journal de référence et le journal associé dans un état où les opérations régulées incluses dans la série d'opérations sont vérifiées dans chaque journal parmi le journal de référence et le journal associé.

11. Dispositif d'assistance au traçage pour une machine de travail sur carte selon la revendication 9 ou 10, dans lequel la section de présentation est configurée pour extraire une opération d'un opérateur sur la machine de travail sur carte dans chaque journal parmi le journal de référence et le journal associé, et pour présenter le journal de référence et le journal associé dans un état où l'ordre des opérations respectives est vérifié.

12. Dispositif d'assistance au traçage pour une machine de travail sur carte selon l'une quelconque des revendications 1 à 11, dans lequel la machine de travail sur carte est un dispositif de montage de composants pour monter un composant sur la carte.

13. Dispositif d'assistance au traçage pour une machine de travail sur carte selon la revendication 12, dans lequel la catégorie comprend une catégorie basée sur la carte, un type du composant monté sur la carte, et le nombre de composants.

14. Dispositif d'assistance au traçage pour une machine de travail sur carte selon la revendication 12 ou 13, dans lequel le dispositif de montage de composants est configuré pour inclure un élément de maintien afin de maintenir le composant en fournissant de l'air à pression négative ou de l'air à pression positive à l'élément de maintien lors du travail prédéterminé, et
dans lequel la catégorie comprend une catégorie basée sur une pression d'air ou un débit d'air de l'air à pression négative ou de l'air à pression positive fourni à l'élément de maintien.
